Europäisches Patentamt

European Patent Office

Office européen des brevets

(19)

(11) **EP 0 903 837 B1**

(12) **EUROPEAN PATENT SPECIFICATION**

(45) Date of publication and mention
of the grant of the patent:
**08.11.2006 Bulletin 2006/45**

(51) Int Cl.:
*H02K 11/00* (2006.01)     *H02K 5/16* (2006.01)

(21) Application number: **98402211.1**

(22) Date of filing: **08.09.1998**

(54) **Motor and assembly method of the motor**

Motor und Montageverfahren für den Motor

Moteur et méthode d'assemblage du moteur

(84) Designated Contracting States:
**AT BE CH CY DE DK ES FI FR GB GR IE IT LI LU MC NL PT SE**

(30) Priority: **19.09.1997 JP 27350297**
**29.01.1998 JP 1731698**

(43) Date of publication of application:
**24.03.1999 Bulletin 1999/12**

(73) Proprietor: **VICTOR COMPANY OF JAPAN, LTD.**
**Yokohama-Shi,**
**Kanagawa-Ken (JP)**

(72) Inventors:
• **Sanada, Minoru**
  **Fujieda-shi,**
  **Shizuoka-ken (JP)**
• **Hashimoto, Isamu**
  **Fujieda-shi,**
  **Shizuoka-ken (JP)**

(74) Representative: **Hirsch, Marc-Roger**
**Hirsch & Associés**
**58, Avenue Marceau**
**75008 Paris (FR)**

(56) References cited:
**EP-A- 0 436 721        US-A- 5 461 271**
**US-A- 5 760 521**

**Description**

**BACKGROUND OF THE INVENTION**

Field of the Invention:

The present invention relates to a motor, and in particular, relates to a structure of a stator thereof comprising a magnetic plate and a printed circuit board stacked together by calking and an assembly method of the stator.

Description of the Related Art:

Presently, in a tape recorder and a video tape recorder, a capstan shaft is used in a combination of a pinch roller to transport a magnetic tape at a constant speed. The capstan shaft is driven at a constant speed by a motor. Recently, a direct drive method is employed, wherein the capstan shaft is directly connected to a rotor of a capstan motor.

In such a capstan motor as employing the direct drive method, the capstan motor generally comprises a rotor and a stator. The stator comprises a stator substrate having a magnetic plate made of a zinc steel sheet and a printed circuit board stacked together by calking, a bearing holder for rotatably supporting the capstan shaft through bearings and a stator core having windings and forming magnetic circuits, wherein the the stator core and the bearing holder are fixed to the stator substrate. The capstan shaft is integrally fixed to the rotor thereof.

US 5 461 271 discloses a brushless motor comprising a bearing rotatably supporting a spindle and a rotor mounted on the spindle. A drive magnet rotates integrally with the rotor. A stator core is disposed to face the drive magnet and has a drive coil wound thereon. A base plate is included on which the stator core is mounted. A bearing holder is provided for holding the bearing, which engages the base plate. A fixing plate is arranged for positioning and fixing the bearing holder and the stator core on the base plate. A fastening member is arranged for fastening the fixing plate to the base plate with bearing holder disposed between the base plate and the fixing plate and with the fixing plate engaged with the bearing holder.

US 5 760 521 discloses a motor comprising a rotor unit and a stator unit. The rotor unit includes a multipolar rotor magnet; a gear, disposed away from the center of rotation of the rotor unit with respect to the rotor magnet, for transmitting torque of the rotor unit to the outside; and a rotary shaft disposed at the center of rotation. The stator unit includes a substrate; and a plurality of coils disposed facing the rotor magnet on the substrate, the substrate having a cut-out section between at least two of the plurality of coils, with the cut-out section causing the outer peripheral section of the gear to be exposed.

EP-A-0 436 721 discloses a brushless motor improving the structure for connecting the stator coil to the substrate to facilitate the operation of connection and assembling. The constitution comprises a rotor having a rotor magnet, a stator core on which the stator coil is wound to be opposed to the rotor magnet, a circuit substrate connected to the stator coil, and an insulating core holder which holds a terminal to which the coil will be connected and which mounts the stator core, the core holder being placed on said circuit substrate and said terminal being soldered to terminal portions on the circuit substrate.

Summary of the invention

The invention is defined by the features of the independent claims. Preferred embodiments of the invention are defined in the dependent claims

Other objects and further features of the present invention will be apparent from the following detailed description.

**BRIEF DESCRIPTION OF THE DRAWINGS**

Fig. 1 is a side view showing a calking jig;
Fig. 2 (a) is a plan view showing a structure of a stator in the related art;
Fig. 2 (b) is a side view showing the structure of the stator shown in Fig. 2 (a);
Figs. 3 (a) to 3 (c) are schematic views for explaining a calking process;
Fig. 4 is a plan view showing a capstan motor for VTR (video tape recorder) employing a stator structure of a first embodiment in the present invention;
Fig. 5 is a side view showing the capstan motor shown in Fig. 4;
Fig. 6 is a plan view showing a surface for mounting electric parts on the capstan motor;
Fig. 7 is a plan view showing a stator structure of the first embodiment of the present invention;

Fig. 8 is a sectional view showing a brushless motor of a second embodiment of the present invention;

Fig. 9 is a plan view taken in the direction of an arrow 2 of the brushless motor shown in Fig. 8, wherein a rotor is removed from the brushless motor; and

Fig. 10 is a plan view showing the brushless motor shown in Fig. 9, wherein the calking centroid with respect to calking sections is depicted.

## DETAILED DESCRIPTION OF THE PREFERRED EMBODIMENT

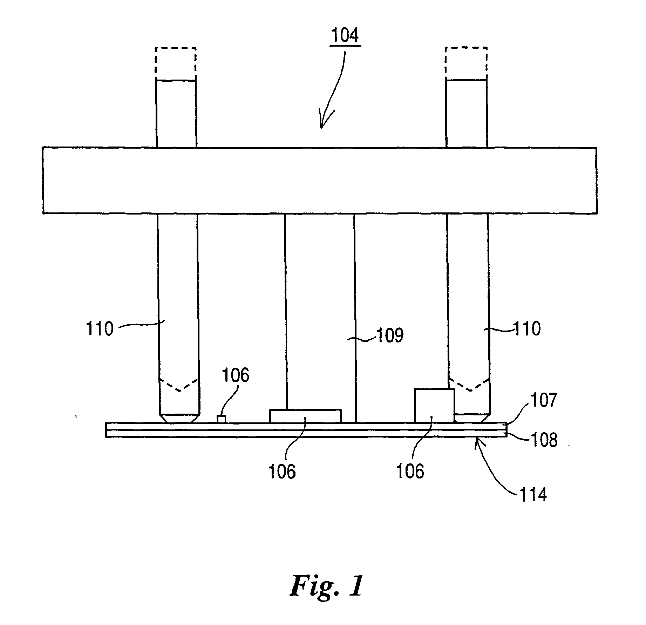

Fig. 1 is a side view showing a calking jig;

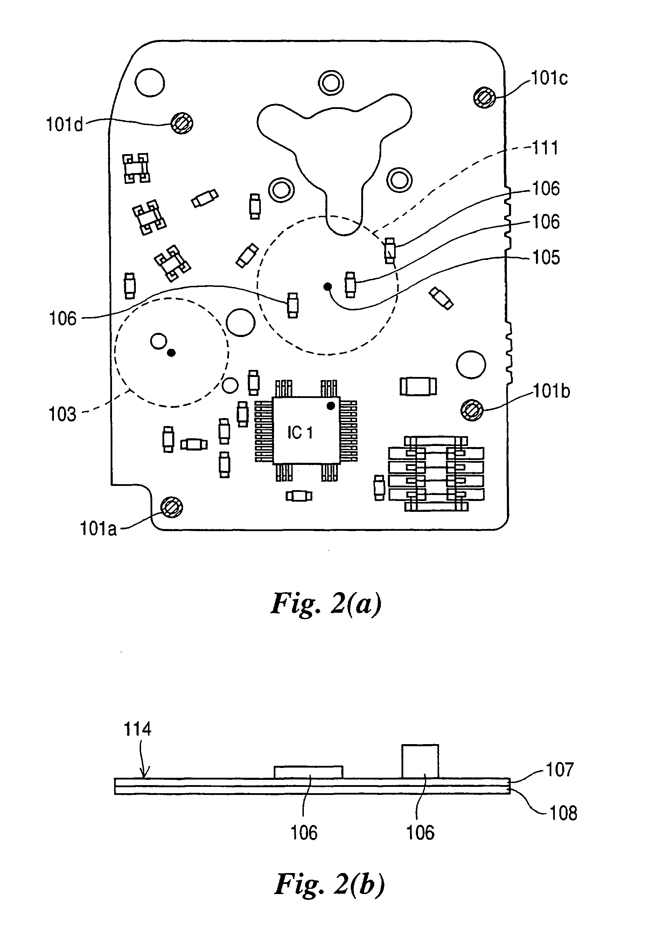

Fig. 2 (a) is a plan view showing a structure of a stator in the related art;

Fig. 2 (b) is a side view showing the structure of the stator shown in Fig. 2 (a); and

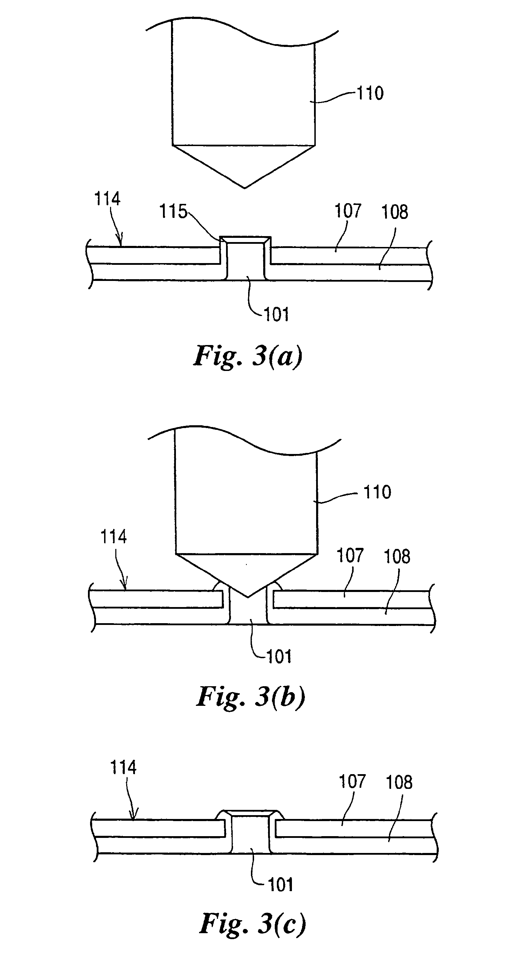

Figs. 3 (a) to 3 (c) are schematic views for explaining a calking process.

Referring to Figs. 2 (a) and 2(b), a stator substrate 114 is formed by stacking a magnetic plate 108 made of a zinc steel sheet and a printed circuit board 107 on which a plurality of electric parts 106 are mounted. In the printed circuit board 107, there are provided plural calking sections 101a, 101b, 101c and 101d.

Upon calking a burring portion 115 of the calking sections 101a, 101b, 101c and 101d, a calking jig 104 is used as shown Fig. 1, wherein a reference character 110 designates a calking pin and 109 a calking retainer for preventing the stator substrate 114 from being displaced when calked.

Referring to Figs. 3 (a) to 3 (c) wherein an exemplary calking pin 110 and a burring portion 115 are depicted, the plural burring portions 115 of the calking sections 101a, 101b, 101c, 101d are calked by being pressed by the calking pins 110, each provided in the calking jig 104 at a position corresponding to each of the positions of the burring portions 115 provided in the stator substrate 114, while a vacant area 103 on the printed circuit board 107 where the electric parts 106 are not provided, is supported by being pressed by the retainer 109.

Referring to Figs. 2(a) and 2(b), a reference character 111 designates a flat circular area having a diameter of 20 mm of which a center corresponds to a centroid 105 (referred to as calking centroid) with respect to the calking sections 101a, 101b, 101c and 101d. However, the flat circular area 111 is not supported by the calking retainer 109 because the some electric parts 106 are provided in the flat circular area 111, thus, the calking retainer 109 is disposed to the vacant area 103.

Generally, in the stator substrate 114 integrally made of the printed circuit board 107 and the magnetic plate 108 being calked, the degree of dimensional accuracy of the printed circuit board 107 is lower than that of the magnetic plate 108. Thus, the printed circuit board 107 is apt to warp or buckle depending on the way of calking the burring portions 115.

In the related art shown in Figs. 2(a) and 2(b), the calking sections 101a, 101d could be calked in a high degree of dimensional accuracy, however, the calking sections 101b, 101c could not be done due to warping and buckling of the printed circuit board 107, resulting in a hollow developed between the printed circuit board 107 and the magnetic plate 108. As a result, there were problems of butting of the stator substrate 114 with the rotor 112 of the motor.

Referring to Figs. 1, 3 (a) to (c) and 4 to 7, the detailed description of the present invention is given of a motor of a first embodiment according to the present invention, wherein like parts are designated with like reference characters in the prior art, and the detailed description is omitted here.

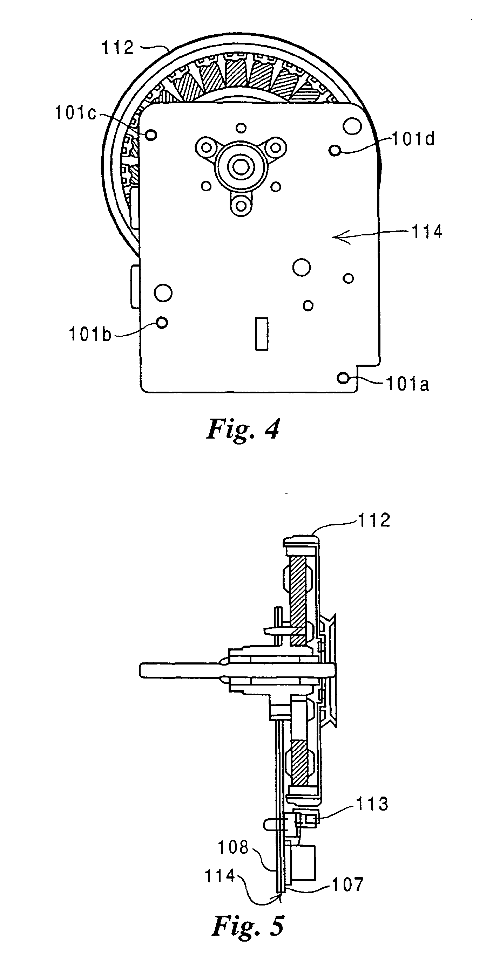

Fig. 4 is a plan view showing a capstan motor for VTR (video tape recorder) employing a stator structure of a first embodiment in the present invention;

Fig. 5 is a side view showing the capstan motor shown in Fig. 4;

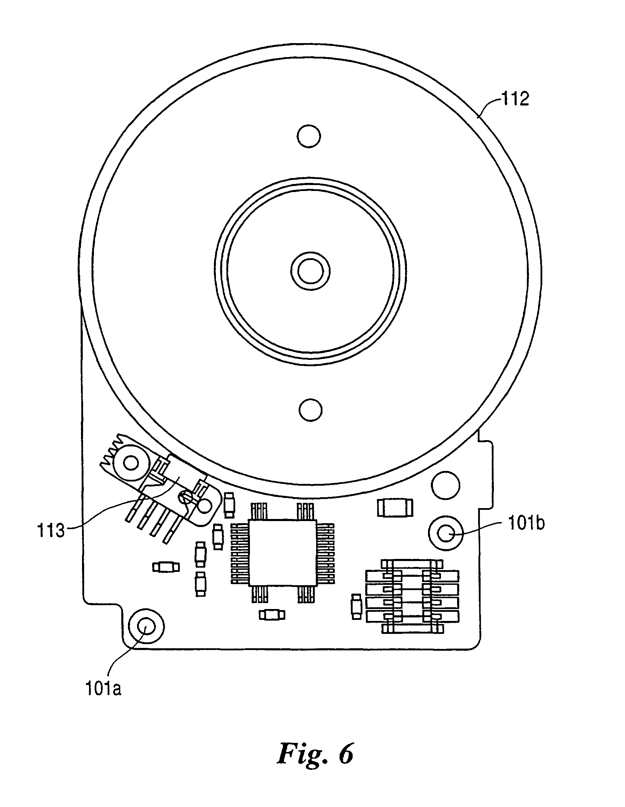

Fig. 6 is a plan view showing a surface for mounting electric parts in the capstan motor; and

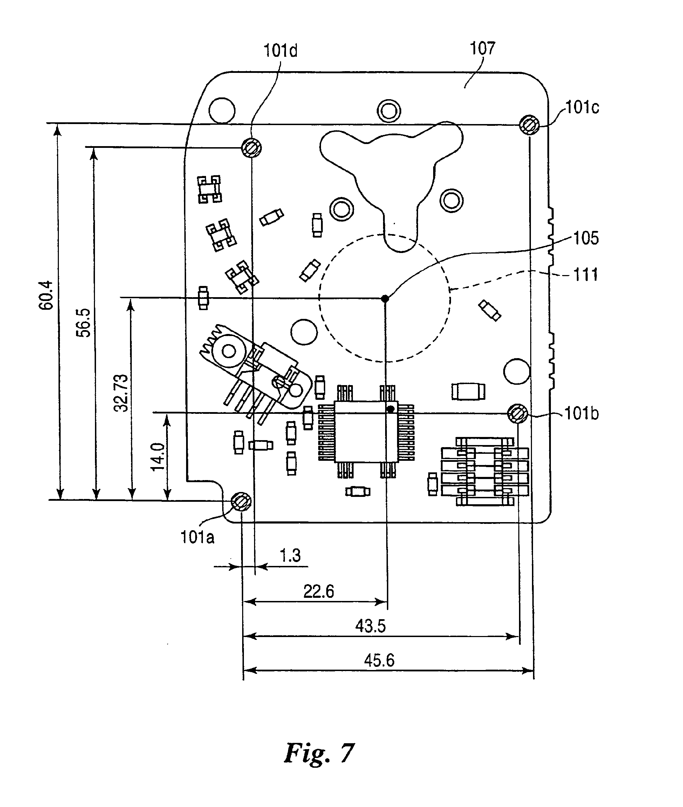

Fig. 7 is a plan view showing a stator structure of the first embodiment in the present invention.

Referring to Figs. 4 and 5, a capstan motor for a VTR of a first embodiment is composed of 24 slots and 16 magnetic poles. Around an outre circumference of a rotor 112, there are provided magnetic sensors 113 of MR elements. A stator substrate 114 has a double-layer structure of a printed circuit board 107 and a zinc steel sheet (as the magnetic plate) 108, which are integrally jointed at four calking sections 101a, 101b, 101c, 101d.

Upon calking, a calking centroid (center of gravity) 105 with respect to the calking sections 101a, 101b, 101c, 101d is determined on the stator substrate 104 by calculating as mentioned hereinafter referring to Fig. 7.

On the printed circuit board 107, there is defined a flat circular section 111 of a diameter of 5 to 20 mm having a center corresponding to the calking centroid 105 mentioned above, and the electric parts 106 are not provided on the flat circular section 111.

Referring to Fig. 1, the calking pins 110 of the calking jig 104 are disposed to butt the calking sections 101a, 101b, 101c, 101d of the stator substrate 114. The calking retainer 109 of the calking jig 104 has a flat surface at an distal end thereof and is disposed to face the flat circular section 111 having its center corresponding to the calking centroid 105 to allow the printed circuit board 107 to be supported.

As shown in Fig. 3(a), the plural burring portions 115 are formed as parts of the zinc steel sheet 108 so as to slightly protrude from the printed circuit board 107. The calking pins 110 of the calking jig 104 are disposed to face the burring portions 115. As shown in Fig. 3(b), the burring portions 115 are pressed from a printed circuit board side by the calking pins 110, resulting in that the burring portions 115 are calked, as shown in Fig. 3 (c). In this case, calking is made by causing the stator substrate 114 to be supported by the calking retainer 109. Thus, it is possible to integrally joint the printed circuit board 107 and the zinc steel sheet 108 together in a high degree of dimensional accuracy.

As mentioned above, the plural calking sections 101a, 101b, 101c, 101d are simultaneously calked by causing the stator substrate 114 to be supported by the calking retainer 109 at the calking centroid 105 of the calking sections 101a, 101b, 101c, 101d and pressing thereof simultaneously by 4 of the calking pins 110. Thus, it is possible to prevent the warp, buckling and rising of the printed circuit board 107 from developing.

Next, the description is given of how to determine the calking centroid 105.

When a position of the calking section 101a is made to be the origin: (0, 0), a distance (mm) from the origin to each of the calking sections 101b, 101c, 101d is expressed in (x, y) coordinates, for instance, as follows.

the calking section 101b: (43.5, 14.0)
the calking section 101c: (45.6, 60.4)
the calking section 101d: (1.3, 56.5)

Thus, when the calking centroid 105 is represented by coordinates (**x, y**), the **x** coordinate and the **y** coordinate are represented as follows.

$$\mathbf{x} = 1/4 (0 + 43.5 + 45.6 + 1.3) = 22.6,$$

and

$$\mathbf{y} = 1/4 (0 + 14.0 + 60.4 + 56.5) = 32.73.$$

Accordingly, the position of the calking centroid 105 can be determined as (**x, y**) = (22.6, 32.6). As mentioned in the foregoing, on the flat circular area 111 having a diameter of 20 mm having the center corresponding to the calking centroid 105, any electric parts 106 are not provided. The diameter of the calking retainer 109 is slightly made smaller than that of the flat circular area 111. Thus, there is no contact of the calking retainer 109 with the electric parts 106, resulting in efficient holding of the printed circuit board 107.

Needless to say, it is possible to optionally determine a size of the flat circular area 111 where the electric parts 106 are not provided, and the size of the diameter of the calking retainer 109 in accordance with the number of the calking sections 101 and the size of the printed circuit board 107.

As mentioned in the foregoing, according to the stator structure of the present invention, the stator substrate has a double-layer structure of the printed circuit board and the zinc steel sheet, and they are calked together at the four calking sections. At that time, the calking centroid is determined from the four calking sections. The electric parts are not provided within the flat circular area having a diameter of 20 mm of which a center corresponds to the calking centroid. Upon calking, the calking sections located around the outer circumference of the flat circular area are calked by causing the flat circular area to be held with the calking retainer. Thus, each of the calking sections in the printed circuit board is equally pressed with the calking pins, resulting in a prevention of the warp and rising of the printed circuit board.

According to the stator structure of the present invention, it is possible to prevent the warp and rising of the printed circuit board. Thereby, the stator substrate is securely made to be a flat plate, resulting in no contact of the stator substrate with the rotor and no vibration in a hollow developed between the printed circuit board and the magnetic plate due to the warp and rising of the printed circuit board.

Further, according to a method of the present invention that the electric parts are not provided on the flat circular area of which center corresponds to the calking centroid, it does not need an additional cost particularly because the printed circuit board can be designed or formed by the ordinary method.

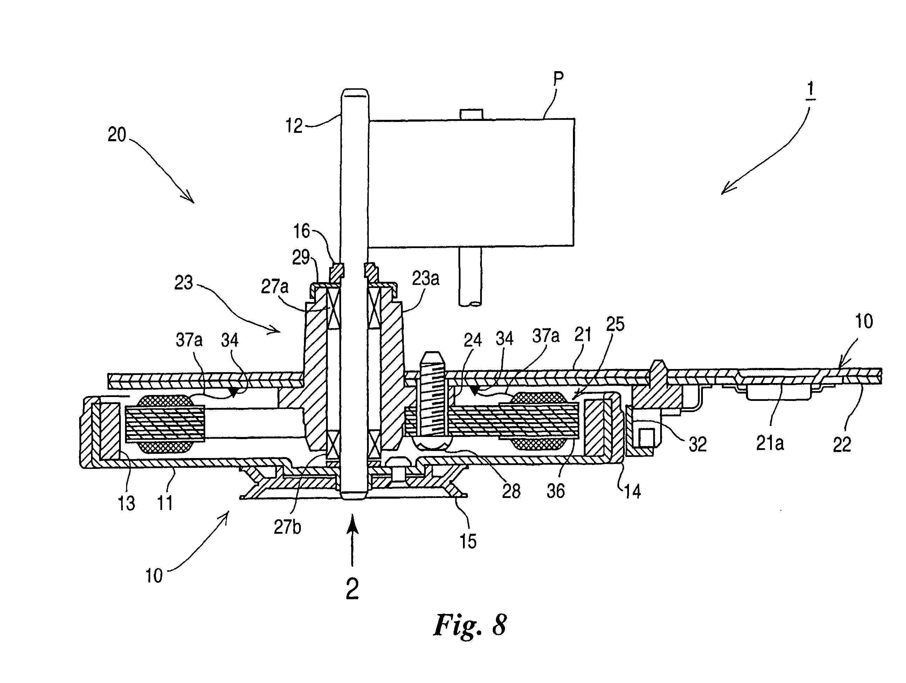

Next, the description is given of a second embodiment of a brushless motor of the present invention referring to Figs. 8 to 10.

Fig. 8 is a sectional view showing a brushless motor of a second embodiment of the present invention;

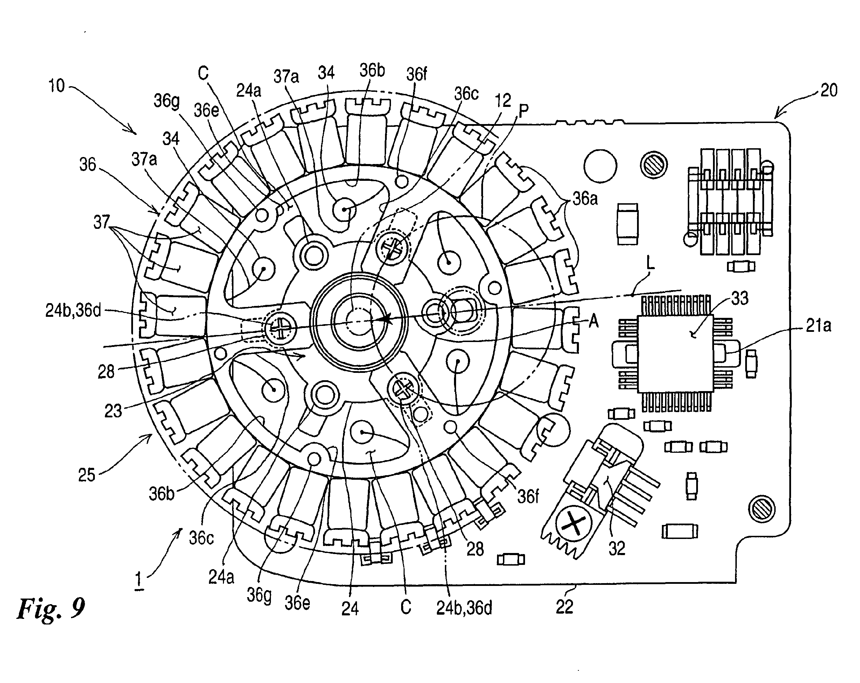

Fig. 9 is a plan view taken in the direction of an arrow 2 of the brushless motor shown in Fig. 8, wherein a rotor is removed from the brushless motor; and

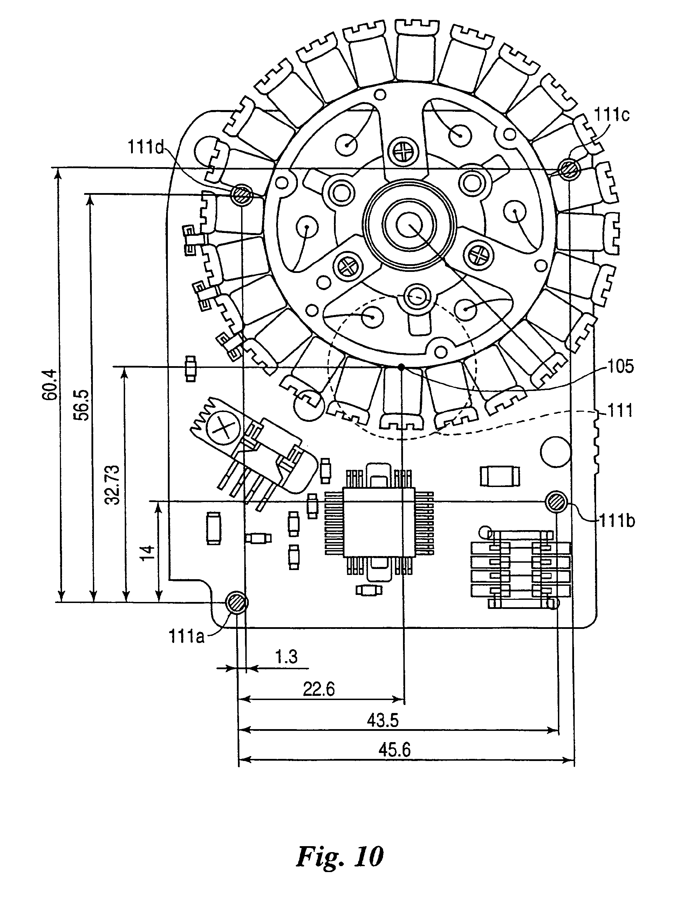

Fig. 10 is a plan view showing the brushless motor shown in Fig. 9, wherein the calking centroid with respect to calking sections is depicted.

As shown in Fig. 8, a brushless motor 1 of a second embodiment of the present invention generally comprises a rotor 10 and a stator 20. The rotor 10 comprises a rotor yoke 11, a capstan shaft 12 provided at a center of the rotor yoke 11, driving magnets 13 provided around an internal circumference of the rotor yoke 11, frequency generating magnets (referred to as FG magnets) 14 and a pulley 15 provided at a center of the rotor yoke 11 for driving external devices and a retainer 16 provided at a middle of the capstan shaft 12.

A stator 20 comprises a motor base 21, a printed circuit board 22 stacked at a bottom of the motor base 21, a bearing holder 23 having a cylindrical section 23a and a flange 24, and a stator coil assembly 25. The cylindrical section 23a of the bearing holder 23 penetrates through both the printed circuit board 22 and the motor base 21. Both the printed circuit board 22 and the motor base 21 are mounted on an upper surface of the flange 24, and the stator coil assembly 25 is mounted on a lower surface of the flange 24.

Reference character 21a designates a protruding section provided in the motor base 21 for contacting with electric parts, 27a and 27b oilless bearings for rotatably supporting the capstan shaft 12, 28 a screw for installing the bearing holder 23, 29 a thrust cup interposed between the bearing holder 23 and the retainer 16, P a pinch roller to drive a tape with the capstan shaft 12.

Referring to Fig. 9, on the printed circuit board 22 there are mounted a magnetic resistance element (referred to as MR element) 32 and IC (integrated circuit) 33, and connecting sections 34 are formed.

The stator coil assembly 25 comprises a ring core 36 and stator coils 37 wound around the ring core 36.

Specifically, the ring core 36 comprises protruding poles 36a for winding plural stator coils 37, a ring section 36b for connecting internal circumference of the protruding poles 36a. The ring section 36b has three installation branches 36c extending toward a center of the ring section 36b for attachment. Further, a reference character 36d designates mounting holes, 36e protruding portions for calking, 36f, 36g calking portions.

Distal ends 37a of each of the stator coils 37 are connected to the connecting sections 34, 34 so as to electrically connect the printed circuit board 22.

Further, a reference character 24a designates motor base installation sections provided in the flange 24, and 24b core installation sections provided in the flange 24.

Referring to Fig. 10, the brushless motor 1 of the second embodiment has the same stator structure as that of the first embodiment in the present invention.

As explained for the first embodiment of the present invention, in the stator structure of the second embodiment of the present invention, the stator substrate 114 has a double-layer structure of the printed circuit board 22 and the motor base 21 made of a zinc steel sheet, and they are calked together at the four calking sections 101a, 101b, 101c, 101d. At that time, the calking centroid 105 is determined from the four calking sections 101a, 101b, 101c, 101d. The electric parts are not provided within the flat circular area 111 having a diameter of 20 mm of which center agrees to the calking centroid 105. Upon calking, the calking sections 101a, 101b, 101c, 101d located around the outer circumference of the flat circular area 111 are calked by causing the flat circular area 111 to be held with the calking retainer 109 of the calking jig 104 shown in Fig. 1. Thus, each of the calking sections 101a, 101b, 101c, 101d in the printed circuit board 22 is equally pressed with the calking pins 110 of the calking jig 104, resulting in a prevention of the warp and rising of the printed circuit board 22.

Next, the description is given of the structural features and the effectiveness thereof in the present invention.

In the ring section 36b, there are defined fan-shaped cutouts C between the installation branches 36c, 36c so that the printed circuit board 22 is partially exposed. The connecting sections 34 are formed on the exposed parts of the printed circuit board 22. Accordingly, it is possible to directly connect the distal ends 37a of the stator coils 37 to the connecting sections 34, this enables an effective assembly of the brushless motor and a reliable brushless motor.

The ring section 36b of the ring core 36 is provided with the three installation branches 36c radially at an equal angular interval protruding toward the center direction of the ring section 36b, and the flange 24 is provided with the motor base installation sections 24a positioned at an equal angular distance from the adjacent installation branches 36c and on a same circumference as that of the core installation section 24b. When the brushless motor 1 is assembled, the motor base 21 and the printed circuit board 22 are mounted together on the flange 24 at the motor base installation section 24a and the ring core 36 is mounted on the flange 24 at the core installation section 24b with the screws 28. Accordingly, upon installing the ring core 36 and the bearing holder 23 in the motor base 21, the installing positions of the ring core 36 and the motor base 21 can be optionally selected in a circumferential direction of the ring section 36b. This feature enables an easy assembly of the brushless motor 1.

Further, in order not to reduce a sectional area of magnetic circuit due to a provision of the calking portion 36g the protruding portions 36e for calking are formed to protrude from the ring section 36b in a semicircular shape toward the center of the ring section 36b, resulting in no variations of magnetic resistance values between the magnetic circuits relative to the protruding poles 36a close to the calking portions 36g and the magnetic circuits of the protruding poles 36a remote from the calking portions 36g. Thus, it is possible to prevent the variation of the magnetic characteristics in the magnetic circuit of the stator 20, resulting in a reduction of unevenness of torque developed by the brushless motor 1.

Upon applying the brushless motor 1 to a device, a pressing direction shown with an arrow A of a pinch roller P is determined along a line L extended from one of the motor base installation section 24a to one of the installation branches 36c. Accordingly, it is possible to prevent an overall inclination of the brushless motor 1, when the capstan shaft 12 is pushed in the direction shown with the arrow A along the line L by the pinch roller P.

According to the present invention, the motor is assembled by causing the flange of the bearing holder to be interposed between the motor base and the plural installation branches together with the printed circuit board underneath, and ends of the stator coils are connected to respective terminal sections provided on the printed circuit board being partially exposed through the cutout portions defined between the plural installation branches of the ring section. Thus, upon installing the ring core and the bearing holder to the motor base, the installing positions of the ring core and the motor can be optionally decided in a circumferential direction of the ring section. This feature enables an easy assembly of the motor.

Further, according to the present invention, a pinch roller of an apparatus is vertically pushed to the capstan shaft of the motor in a direction along a line extended from the capstan shaft to one of the plural branch sections.

Thereby, the inclination of the capstan shaft of the motor caused by the pushing force exerted from the pinch roller is effectively prevented.

## Claims

1.  A motor (1) including, in combination, a rotor (10, 112) ; and a stator (20), with the stator (20) comprising:

    a stator structure;
    a bearing holder (23) mounted on the stator structure ; and
    a magnetic core section (36) having a plurality of stator coils (37) and
    with
    the rotor (10) comprising ;
    a capstan shaft (12) rotatably supported by the bearing holder (23) through bearing means (27a, 27b); and
    a rotor yoke (11) provided at an end of the capstan shaft (12), wherein the rotor (10) is rotated by a mutual magnetic action between magnets provided on the rotor yoke (11) and the plurality of the stator coils (37) of the stator (20),
    the motor (1) being **characterized in that** the bearing holder (23) in the stator has a flange (24) protruding therefrom, which includes motor base installation sections (24a) and core installation sections (24b), and
    that the magnetic core section (36) has a ring section (36b) provided with plural magnetic cores around an outer circumference thereof and has plural installation branches (36c) protruding radially toward a center of the ring section (36b) and having installation portions connected respectively to the core installation sections (24b) of the flange (24), and wherein the plural installation branches (36c) define cutout portions (C) therebetween, with the flange (24) of the bearing holder (23) being interposed between the stator structure and the plural installation branches (36c) together with a printed circuit board (22, 107) disposed such that the underneath ends (37a) of stator coils (37) are connected to respective terminal sections (34) provided on the printed circuit board (22, 107) partially exposed through cutout portions (C) defined between the plural installation branches (36c) of the ring section (36b).

2.  A motor (1) as claimed in claim 1, wherein the plural installation branches (36c) are three installation branches disposed at an equal angular interval therebetween, and wherein the motor base installation sections (24a) are disposed at an equal angular distance from two adjacent installation branches (36c) and on a circumference on which the installation portions are also disposed circularly with respect to the center of the ring section (36b).

3.  A motor (1) as claimed in claim 1, wherein said stator structure comprises a stator substrate (114) having a double-layer structure of a printed circuit board (22, 107) and a magnetic plate (21, 108) jointed together at a plurality of calking sections (101a-101d),
    the stator substrate is **characterized in that** a centroid (105) is determined with respect to the plurality of calking sections (101a-101d) on the stator substrate (114), and
    that the centroid (105) defines a vacant area (103) having no electric parts disposed nearby the centroid (105) on the printed circuit board (22, 107) to allow the vacant area (103) to be supported by a supporter of a calking jig (104).

4.  A method of assembling a motor composed of a stator (20) and a rotor (10, 112), with the stator (20) including a stator structure and a magnetic core section having plurality installation branches, the method comprising the steps of:

mounting a bearing holder (23) having a flange (24) on the stator structure with the flange (24) having motor base installation sections (24a) ;

mounting a capstan shaft (12) rotatably supported by the bearing holder (23) through bearing means (27a, 27b); and

mounting a rotor yoke (11) on an end of the capstan shaft (12), wherein the rotor (10) is rotated by a mutual magnetic action between magnets provided on the rotor yoke (11) and the plurality of the stator coils (37) of the stator (20); and

wherein the method is **characterized by** assembling the motor (1) such that the flange (24) of the bearing holder (23) is interposed between the stator structure and the plural installation branches (36c) in such a manner that the motor base installation sections (24a) of the flange (24) are exposed between the plural installation branches (36c) of the magnetic core section; and

wherein a pinch roller (P) is disposed on and pushed along a line toward the capstan shaft (12) of the motor (1), extending from one of the motor base installation sections (24a) to one of the plural installation branches (36c).

**5.** A method as claimed in claim 4,,wherein the stator structure includes a stator substrate (114) having a double-layer structure of a printed circuit board (22, 107) and a magnetic plate (21, 108) jointed together at a plurality of calking sections (101a-101d), the method comprising steps of:

determining a centroid (105) with respect to the plurality of calking sections (101a-101d) on the stator substrate (114);

defining a vacant area (103) without electric parts mounted nearby the centroid (105) on the printed circuit board (22, 107);

calking the plurality of calking sections (101a-101d) by using a calking jig (104) having a plurality of calking pins (110) for pressing the plurality of calking sections (101a-101d) and having a retainer section (109) for supporting the stator substrate (114),

said method being **characterized in that** the plurality of calking pins (110) are disposed at positions agreeing to the plurality of calking sections (101a-101d) provided on the printed circuit board (22, 107) and

that the retainer section (109) is disposed facing a vicinity of the centroid (105) so as to allow the retainer section (109) to support the vacant area (103) when the plurality of calking sections (101a-101d) are calked by the plurality of the calking pins (110) of the calking jig (104).

**Patentansprüche**

**1.** Motor (1) umfassend eine Kombination aus einem Rotor (10, 112); und einem Stator (20), wobei der Stator (20) umfasst:

eine Stator-Struktur;
einen Lagerhalter (23), welcher auf der Stator-Struktur angebracht ist; und
eine Magnet-Kern-Sektion (36) mit einer Mehrzahl von Stator-Spulen (37) und
wobei der Rotor (10) umfasst:

eine Kapstan-Welle (12), welche durch den Lagerhalter (23) über Lagermittel (27a, 27b) drehbar gehaltert wird; und
ein Rotor-Joch (11), welches an einem Ende der Kapstan-Welle (12) ausgebildet ist, wobei der Rotor (10) durch eine magnetische Wechselwirkung zwischen Magneten, welche auf dem Rotor-Joch (11) ausgebildet sind, und der Mehrzahl von Stator-Spulen (37) des Stators (20) rotiert wird,
**dadurch gekennzeichnet,**
**dass** der Lagerhalter (23) in dem Stator einen davon hervorstehenden Flansch (24) besitzt, welcher Motor-Basis-Montage-Sektionen (24a) und Kern-Montage-Sektionen (24b) umfasst, und
**dass** die Magnet-Kern-Sektion (36) eine Ring-Sektion (36b), welche mit mehreren Magnet-Kernen um einen äußeren Umfang derselben ausgestattet ist, und mehrere Montagearme (36c) besitzt, welche radial in Richtung einer Mitte der Ring-Sektion (36b) hervorstehen und Montage-Abschnitte besitzen, welche jeweils mit den Kern-Montage-Sektionen (24b) des Flansches (24) verbunden sind, und wobei die mehreren Montage-Arme (36c) dazwischen liegende Ausnehmungs-Abschnitte (C) definieren, und der Flansch (24) des Lagerhalters (23) zwischen der Stator-Struktur und den mehreren Montagearmen (36c) liegt, zusammen mit einer Leiterplatine (22, 107), welche so angeordnet ist, dass die unten liegenden Enden (37a) der Stator-Spulen (37) mit jeweiligen Anschluss-Sektionen (34) verbunden sind, welche auf der Leiterplatine (22, 107)

7

ausgebildet sind und durch die Ausnehmungs-Abschnitte (C), welche zwischen den mehreren Montagearmen (36c) der Ring-Sektion (36b) definiert sind, teilweise offen liegen.

2. Motor (1) nach Anspruch 1,
**dadurch gekennzeichnet, dass** die mehreren Montagearme (36c) drei Montagearme sind, welche mit einem gleichen Winkelintervall zwischen denselben angeordnet sind, und dass die Motor-Basis-Montage-Sektionen (24a) mit einer gleichen Winkeldistanz von zwei benachbarten Montagearmen (36c) und auf einem Umfang angeordnet sind, auf welchem die Montage-Abschnitte ebenfalls kreisförmig in Bezug auf die Mitte der Ring-Sektion (36b) angeordnet sind.

3. Motor (1) nach Anspruch 1,
wobei die Stator-Struktur ein Stator-Substrat (114) umfasst, mit einer Doppel-Schicht-Struktur einer Leiterplatine (22, 107) und einer magnetischen Platte (21, 108), welche miteinander an einer Mehrzahl von Verstemmungs-Sektionen (101a-101d) verbunden sind, und
das Stator-Substrat **dadurch gekennzeichnet ist, dass** ein Schwerpunkt (105) in Bezug auf die Mehrzahl von Verstemmungs-Sektionen (101a-101d) auf dem Stator-Substrat (114) bestimmt ist, und
dass der Schwerpunkt (105) einen freien Bereich (103) definiert, in welchem auf der Leiterplatine (22, 107) keine elektrischen Bauteile in der Nähe des Schwerpunktes (105) angebracht sind, um zu gestatten, dass der freie Bereich (103) durch einen Träger einer Verstemmungs-Vorrichtung (104) unterstützt wird.

4. Verfahren zur Montage eines Motors, welcher einen Stator (20) und einen Rotor (10, 112) umfasst, wobei der Stator (20) eine Stator-Struktur und eine Magnet-Kern-Sektion umfasst, mit einer Mehrzahl von Montage-Armen, wobei das Verfahren die Schritte umfasst:

Anbringen eines Lagerhalters (23) mit einem Flansch (24) auf der Stator-Struktur, wobei der Flansch (24) Motor-Basis-Montage-Sektionen (24a) besitzt;
Anbringen einer Kapstan-Welle (12), welche über Lagermittel (27a, 27b) durch den Lagerhalter (23) drehbar gehaltert wird; und
Anbringen eines Rotor-Jochs (11) an einem Ende der Kapstan-Welle (12), wobei der Rotor durch eine magnetische Wechselwirkung zwischen auf dem Rotor-Joch (11) angebrachten Magneten und der Mehrzahl von Stator-Spulen (37) des Stators (20) rotiert wird;
**gekennzeichnet durch**
Montieren des Motors (1), so dass der Flansch (24) des Lagerhalters (23) derart zwischen der Stator-Struktur und den mehreren Montage-Armen (36c) liegt, dass die Motor-Basis-Montage-Sektionen (24a) des Flansches (24) zwischen den mehreren Montagearmen (36c) der Magnet-Kern-Sektion offen liegen; und
wobei eine Andruckrolle (P) auf einer Linie, welche sich von einer der Motor-Basis-Montage-Sektionen (24a) zu einem der mehreren Montagearme (36c) erstreckt, angeordnet ist und entlang dieser in Richtung der Kapstan-Welle (12) des Motors (1) gedrückt wird.

5. Verfahren nach Anspruch 4, wobei die Stator-Struktur ein Stator-Substrat (114) umfasst, mit einer Doppel-Schicht-Struktur einer Leiterplatine (22, 107) und einer magnetischen Platte (21, 108), welche an einer Mehrzahl von Verstemmungs-Sektionen (101a-101d) miteinander verbunden sind, umfassend die Schritte:

Bestimmen eines Schwerpunktes (105) in Bezug auf die Mehrzahl von Verstemmungs-Sektionen (101a-101d) auf dem Stator-Substrat (114);
Definieren eines freien Bereiches (103) ohne in der Nähe des Schwerpunktes (105) auf der Leiterplatine (22, 107) angebrachte elektrische Bauteile;
Verstemmen der Mehrzahl von Verstemmungs-Sektionen (101a-101d) unter Verwendung einer Verstemmungs-Vorrichtung (104) mit einer Mehrzahl von Verstemmungs-Stiften (110) zum Pressen der Mehrzahl von Verstemmungs-Sektionen (101a-101d) und mit einer Halterungs-Sektion (109) zum Unterstützen des Stator-Substrats (114),
**dadurch gekennzeichnet,**
**dass** die Mehrzahl von Verstemmungs-Stiften (110) an Positionen angeordnet sind, welche mit der auf der Leiterplatine (22, 107) angeordneten Mehrzahl von Verstemmungs-Sektionen (101a-101d) übereinstimmen und
**dass** die Halterungs-Sektion (109) einer Umgebung des Schwerpunktes (105) gegenüberliegend angeordnet ist, um zu gestatten, dass die Halterungs-Sektion (109) den freien Bereich (103) unterstützt, wenn die Mehrzahl von Verstemmungs-Sektionen (101a-101d) durch die Mehrzahl von Verstemmungs-Stiften (110) der Verstemmungs-Vorrichtung (104) verstemmt werden.

**EP 0 903 837 B1**

**Revendications**

**1.** Moteur (1) incluant, en combinaison, un rotor (10, 112) ; et un stator (20), le stator (20) comprenant :

- une structure de stator ;
- un support de palier (23) monté sur la structure de stator ; et
- une partie de noyau magnétique (36) ayant une pluralité de bobines de stator (37) et

avec le rotor (10) comprenant :

- un arbre de cabestan (12) supporté de manière rotative par le support de palier (23) via des moyens de palier (27a, 27b) ; et
- une culasse de rotor (11) prévue sur une extrémité de l'arbre de cabestan (12), dans lequel le rotor (10) est entraîné en rotation par une action magnétique mutuelle entre des aimants prévus sur la culasse de rotor (11) et la pluralité de bobines de stator (37) du stator (20),

le moteur (1) étant **caractérisé en ce que** le support de palier (23) dans le stator a une bride (24) faisant saillie de celui-ci et qui comporte des parties (24a) d'installation de base du moteur et des parties (24b) d'installation de noyau, et

**en ce que** la partie de noyau magnétique (36) présente une partie annulaire (36b) munie de plusieurs noyaux magnétiques autour d'une circonférence extérieure de celle-ci et a plusieurs branches d'installation (36c) faisant saillie radialement vers un centre de la partie annulaire (36b) et ayant des parties d'installation raccordées respectivement aux parties d'installation de noyau (24b) de la bride (24), et dans lequel plusieurs branches d'installation (36c) définissent des parties découpées (C) entre elles, la bride (24) du support de palier (23) étant interposée entre la structure de stator et plusieurs branches d'installation (36c) avec une carte de circuit imprimé (22, 107) placée de sorte que les extrémités (37a) des bobines de stator (37) soient reliées à des parties respectives (34) de la borne prévues sur la carte de circuit imprimé (22, 107) et partiellement exposées par les parties découpées (C) définies entre plusieurs branches d'installation (36c) de la partie annulaire (36b).

**2.** Moteur (1) selon la revendication 1, dans lequel plusieurs branches d'installation (36c) sont trois branches d'installation placées à un intervalle angulaire égal entre elles et dans lequel les parties d'installation de base du moteur (24a) sont placées à une distance angulaire égale de deux branches d'installation (36c) et sur une circonférence sur laquelle les parties d'installation sont également placées de manière circulaire par rapport au centre de la partie annulaire (36b).

**3.** Moteur (1) selon la revendication 1, dans lequel ladite structure de stator comprend un substrat de stator (114) ayant une structure à double couche d'une carte de circuit imprimé (22, 107) et d'une plaque magnétique (21, 108) jointes ensemble sur une pluralité de parties d'assemblage par matage ou rivetage (101a à 101d), le substrat de stator est **caractérisé en ce qu'**une partie centrale ou centroïde (105) est déterminée par rapport à la pluralité de parties d'assemblage par matage ou rivetage (101a à 101d) sur le substrat de stator (114), et **en ce que** le centroïde (105) définit une zone libre (103) n'ayant aucune pièce électrique placée près du centroïde (105) sur la carte de circuit imprimé (22, 107) pour permettre à la zone libre (103) d'être supportée par un support d'un montage d'assemblage par matage ou rivetage (104).

**4.** Procédé d'assemblage d'un moteur composé d'un stator (20) et d'un rotor (10, 112), le stator (20) comprenant une structure de stator et une partie de noyau magnétique ayant une pluralité de branches d'installation, le procédé comprenant les étapes consistant à :

- monter un support de palier (23) ayant une bride (24) sur la structure de stator, la bride (24) ayant des parties (24a) d'installation de base du moteur;
- monter un arbre de cabestan (12) supporté de manière rotative par le support de palier (23) via des moyens de palier (27a, 27b) ; et
- monter une culasse de rotor (11) sur une extrémité de l'arbre de cabestan (12), dans lequel le moteur (10) est entraîné en rotation par une action magnétique mutuelle entre des aimants prévus sur la culasse de rotor (11) et la pluralité de bobines de stator (37) du stator (20) ; et

dans lequel le procédé est **caractérisé par** l'assemblage du moteur (1) de telle manière que la bride (24) du support de palier (23) est interposée entre la structure de stator et les plusieurs branches d'installation (36c) de sorte que

**9**

les parties d'installation de base du moteur (24a) de la bride (24) soient exposées entre les plusieurs branches d'installation (36c) de la partie de noyau magnétique ; et

dans lequel un galet presseur (P) est placé sur et poussé le long d'une ligne en direction de l'arbre de cabestan (12) du moteur (1), s'étendant depuis l'une des parties d'installation de base du moteur (24a) vers l'une des plusieurs branches d'installation (36c).

5. Procédé selon la revendication 4, dans lequel la structure de stator comprend un substrat de stator (114) ayant une structure à double couche d'une carte de circuit imprimé (22, 107) et une plaque magnétique (21, 108) jointes ensemble sur une pluralité de parties d'assemblage par matage ou rivetage (101a à 101d), le procédé comprenant les étapes consistant à :

- déterminer une partie centrale ou centroïde (105) par rapport à la pluralité de parties d'assemblage par matage ou rivetage (101a à 101 d) sur le substrat de stator (114) ;
- définir une zone libre (103) sans pièce électrique placée près du centroïde (105) sur la carte de circuit imprimé (22, 107),
- assembler par matage ou rivetage la pluralité de parties d'assemblage par matage ou rivetage (101a à 101d) à l'aide d'un montage d'assemblage par matage ou rivetage (104) ayant une pluralité de broches de matage ou de rivetage (110) pour presser la pluralité de parties d'assemblage par matage ou rivetage (101a à 101 d) et ayant une partie de retenue (109) pour supporter le substrat de stator (114) ;

ledit procédé étant **caractérisé en ce que** la pluralité de broches d'assemblage par matage ou rivetage (110) sont placées dans des positions correspondant à la pluralité de parties d'assemblage par matage ou rivetage (101a à 101d) prévues sur la carte de circuit imprimé (22, 107) et

**en ce que** la partie de retenue (109) est placée en faisant face à une proximité du centroïde (105) de façon à permettre à la partie de retenue (109) de supporter la zone libre (103) lorsque la pluralité de parties d'assemblage par matage ou rivetage (101a à 101d) sont assemblées par matage ou rivetage par la pluralité de broches d'assemblage par matage ou rivetage (110) du montage d'assemblage par matage ou rivetage (104).

**Fig. 1**

**Fig. 2(a)**

**Fig. 2(b)**

**Fig. 3(a)**

**Fig. 3(b)**

**Fig. 3(c)**

112

101c

101d

114

101b

101a

***Fig. 4***

112

113

108

114

107

***Fig. 5***

**Fig. 6**

*Fig. 7*

*Fig. 8*

**Fig. 9**

EP 0 903 837 B1

*Fig. 10*